# EUROPEAN PATENT APPLICATION

(11) **EP 4 727 291 A1**
(43) Date of publication of application: **15.04.2026**
(21) Application number: 25171993.6
(22) Date of filing: 23.04.2025
(51) Int. Cl.: H10D 84/80, H10D 30/66, H10D 84/03

(54) **SEMICONDUCTOR DEVICE**

(30) Priority: 11.10.2024 TW 113138673
(71) Applicant: ProAsia Semiconductor Corporation, Hsinchu 30078 (TW)
(72) Inventor: KUO, Ming-Chi, 30078 Hsinchu (TW); LEE, Wen-Chung, 30078 Hsinchu (TW)
(74) Representative: Michalski Hüttermann & Partner Patentanwälte mbB

(57) **Abstract**

A semiconductor device is provided. The semiconductor device comprises a substrate, a transistor and a snubber circuit. The transistor and the snubber circuit are disposed on the same substrate, and are electrically connected. The snubber circuit has a polycrystalline silicon layer and a dielectric layer, which are adjacently arranged and electrically connected in series. The polycrystalline silicon layer is electrically connected to a source of the transistor, and the dielectric layer is electrically connected to a drain of the transistor so that the polycrystalline silicon layer acts as a resistor, the dielectric layer acts as a capacitor and the snubber circuit acts as an RC snubber circuit.

## Description

### CROSS-REFERENCES TO RELATED APPLICATIONS

This application claims the benefit of priority to Taiwanese Patent Application No. 113138673 filed on October 11, 2024, which is hereby incorporated by reference in its entirety.

### BACKGROUND OF THE INVENTION

### Field of the Invention

The present invention relates to a semiconductor device, and in particular to a semiconductor device capable of suppressing voltage surges.

### Descriptions of the Related Art

In application circuits of power transistors, parasitic inductance exists, which causes significant voltage surges and ringing phenomena when the power transistor is turned off. In addition to generating electromagnetic interference (EMI) in the application circuit, when the surge exceeds the rated value of the component, it may even lead to damage to the power transistor or other electronic components in the circuit.

To dissipate surge energy, a common approach is to externally add a snubber circuit, particularly in circuits involving high-speed switching of large currents, where to arrange a snubber circuit in the circuitry is especially necessary. Among the various types of external snubbers, the resistor-capacitor snubber (RC snubber) is the most commonly used. However, adding an external RC snubber circuit to the application circuit of a power transistor incurs additional costs. In summary, the voltage surges and ringing phenomena caused by parasitic inductance during the turn-off of a power transistor are significant issues in power transistor applications. While an external RC snubber circuit is effective, it increases both cost and the complexity of circuit design. Therefore, effectively suppressing voltage surges in power transistors without significantly increasing component costs remains an urgent problem for the industry to address.

### SUMMARY OF THE INVENTION

The primary objective of the present invention is to provide an innovative semiconductor device that integrates an RC snubber circuit into the structural design of the power transistor itself so that there is no need for an external snubber in the application circuit for effectively suppressing voltage surges during switching of the power transistor and thereby protecting the gate oxide layer of the power transistor from damage.

To achieve the above objective, the present invention provides a semiconductor device comprising a substrate, a transistor, and a snubber circuit. The transistor and the snubber circuit are disposed on the same substrate, and the snubber circuit is electrically connected to the transistor. The snubber circuit includes a polycrystalline silicon layer and a dielectric layer, adjacently arranged and electrically connected in series. The polycrystalline silicon layer is electrically connected to a source of the transistor, and the dielectric layer is electrically connected to a drain of the transistor, so that the polycrystalline silicon layer acts as a resistor and the dielectric layer acts as a capacitor for forming a resistor-capacitor snubber circuit.

In one embodiment of the semiconductor device of the present invention, the substrate is a silicon carbide substrate.

In one embodiment of the semiconductor device of the present invention, the semiconductor device further comprises an epitaxial layer disposed on the substrate, wherein the dielectric layer is disposed on the epitaxial layer.

In one embodiment of the semiconductor device of the present invention, the semiconductor device further comprises a drain metal disposed on a backside of the substrate, acting as the drain, wherein the polycrystalline silicon layer, the epitaxial layer, and the substrate between the source metal and the drain metal exhibit the resistance.

In one embodiment of the semiconductor device of the present invention, the semiconductor device further comprises a source metal disposed above the epitaxial layer, electrically connected to the source and the polycrystalline silicon layer.

To achieve the above objective, the present invention provides a semiconductor device comprising a substrate, a transistor, and a snubber circuit. The transistor and the snubber circuit are disposed on the same substrate, and the snubber circuit is electrically connected to the transistor. The snubber circuit includes a polycrystalline silicon layer and a dielectric layer, adjacently arranged and electrically connected in series, wherein the polycrystalline silicon layer is electrically connected to a gate of the transistor, and the dielectric layer is electrically connected to a source of the transistor, so that the polycrystalline silicon layer acts as a resistor and the dielectric layer acts as a capacitor.

In one embodiment of the semiconductor device of the present invention, the semiconductor device further comprises an epitaxial layer and an interlayer dielectric layer, the epitaxial layer being disposed on the substrate, and the interlayer dielectric layer being disposed on the epitaxial layer, wherein the polycrystalline silicon layer is disposed on the interlayer dielectric layer.

In one embodiment of the semiconductor device of the present invention, the semiconductor device further comprises a gate metal disposed on the interlayer dielectric layer, electrically connected to the gate, wherein the polycrystalline silicon layer and the gate metal have the resistance therebetween.

In one embodiment of the semiconductor device of the present invention, the semiconductor device further comprises a source metal disposed above the interlayer dielectric layer, electrically connected to the source and the dielectric layer.

To achieve the above objective, the present invention provides a semiconductor device comprising a substrate, a transistor, a first snubber circuit, and a second snubber circuit. The transistor, the first snubber circuit, and the second snubber circuit are disposed on the same substrate, and the first snubber circuit and the second snubber circuit are electrically connected to the transistor. The first snubber circuit includes a first polycrystalline silicon layer and a first dielectric layer, adjacently arranged and electrically connected in series. The second snubber circuit includes a second polycrystalline silicon layer and a second dielectric layer, adjacently arranged and electrically connected in series. The first polycrystalline silicon layer is electrically connected to a source of the transistor, and the first dielectric layer is electrically connected to a drain of the transistor, so that the first polycrystalline silicon layer acts as a first resistor and the first dielectric layer acts as a first capacitor. The second polycrystalline silicon layer is electrically connected to a gate of the transistor, and the second dielectric layer is electrically connected to the source of the transistor, so that the second polycrystalline silicon layer acts as a second resistor and the second dielectric layer acts as a second capacitor.

In one embodiment of the semiconductor device of the present invention, the semiconductor device further comprises an epitaxial layer disposed on the substrate, wherein the first dielectric layer is disposed on the epitaxial layer.

In one embodiment of the semiconductor device of the present invention, the semiconductor device further comprises an interlayer dielectric layer disposed on the epitaxial layer, wherein the second polycrystalline silicon layer is disposed on the interlayer dielectric layer.

In one embodiment of the semiconductor device of the present invention, the semiconductor device further comprises a gate metal disposed on the interlayer dielectric layer, electrically connected to the gate, wherein the second polycrystalline silicon layer and the gate metal have the second resistance therebetween.

In one embodiment of the semiconductor device of the present invention, the semiconductor device further comprises a source metal disposed above the interlayer dielectric layer, electrically connected to the source, the first polycrystalline silicon layer, and the second dielectric layer.

In one embodiment of the semiconductor device of the present invention, the semiconductor device further comprises a drain metal disposed on a backside of the substrate, acting as the drain, wherein the first polycrystalline silicon layer, the epitaxial layer, and the substrate between the source metal and the drain metal exhibit the first resistance.

After referring to the drawings and the embodiments described subsequently, those skilled in the art will understand the other objectives of the present invention, as well as the technical means and embodiments of the present invention.

### BRIEF DESCRIPTION OF THE DRAWINGS

FIG. 1 is a circuit schematic of a power transistor device according to the first embodiment of the present invention;
FIG. 2 is a cross-sectional schematic of the power transistor device according to the first embodiment of the present invention;
FIG. 3 is a circuit schematic of a power transistor device according to the second embodiment of the present invention;
FIG. 4 is a cross-sectional schematic of the power transistor device according to the second embodiment of the present invention;
FIG. 5 is a circuit schematic of a power transistor device according to the third embodiment of the present invention; and
FIG. 6 is a cross-sectional schematic of the power transistor device according to the third embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

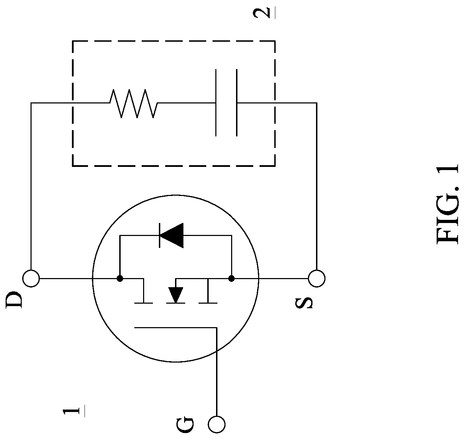

Please refer to FIG. 1, which illustrates a circuit schematic of a semiconductor device according to the first embodiment of the present invention, specifically a power transistor device. In addition to having a transistor 1 identical to conventional designs, this power transistor device further includes a snubber circuit 2 embedded in the device with the transistor 1. This enables the power transistor device of the first embodiment to suppress voltage surges and protect the oxide dielectric layer of the gate G of the transistor from damage without requiring additional external surge protection circuits. Specifically, as shown in FIG. 1, the snubber circuit 2 of this embodiment is a resistor-capacitor (RC) snubber circuit connected between a source S and a drain D of the transistor 1.

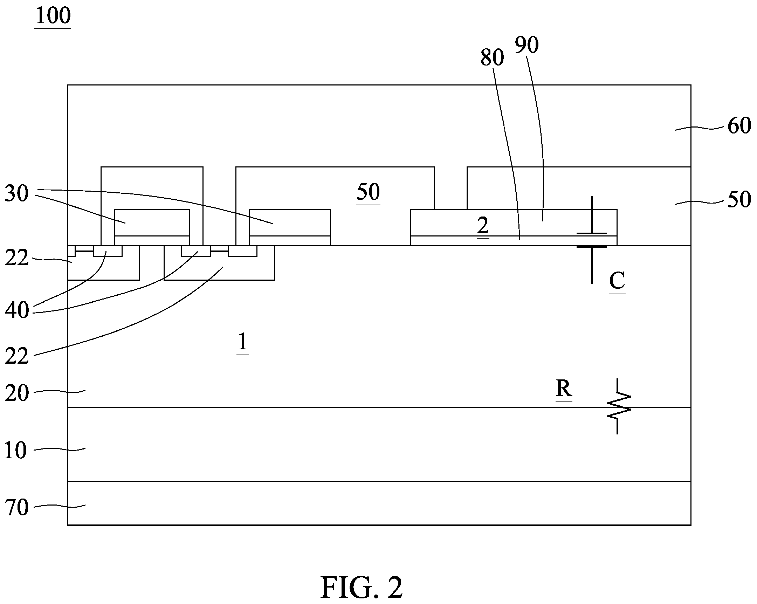

Please refer to FIG. 2 together, which illustrates a cross-sectional schematic of the power transistor device according to the first embodiment of the present invention as shown in FIG. 1. Evidently, the power transistor device 100 of the present invention integrates the transistor 1 and the snubber circuit 2 on the same substrate within a single device structure, as detailed below. This power transistor device 100 includes a substrate 10, specifically an N-type heavily doped silicon carbide substrate, though not limited thereto. An epitaxial layer 20 is disposed on the substrate 10, which may similarly be an N-type lightly doped silicon carbide epitaxial layer, though not limited thereto. Next, a patterned dielectric layer and a patterned polycrystalline silicon layer are sequentially formed on the epitaxial layer 20. The dielectric layer may be a silicon dioxide layer or a silicon nitride layer. A portion of the patterned dielectric layer and patterned polycrystalline silicon layer may act as the gate 30 in the structure of the transistor 1, while other portions of the patterned dielectric layer 80 and patterned polycrystalline silicon layer 90 may act as the capacitor and the resistor in the snubber circuit 2, adjacently arranged and electrically connected in series, as described later.

As shown in FIG. 2, the gate 30 is then used as a mask to sequentially form a P-type well region 22 of the transistor 1 and an N-type heavily doped source 40 of the transistor 1 in the surface region of the epitaxial layer 20. Subsequently, an interlayer dielectric layer 50 is formed on the epitaxial layer 20, covering the gate 30 and the dielectric layer 80 and polycrystalline silicon layer 90 of the snubber circuit 2. Finally, a metallization interconnect process is performed to form a gate metal (not shown), a source metal 60, and a drain metal 70, respectively. The source metal 60 is electrically connected not only to the source 40 of the transistor 1 but also to the polycrystalline silicon layer 90 of the snubber circuit 2. The drain metal 70 is electrically connected to the dielectric layer 80 of the snubber circuit 2 through the substrate 10 and the epitaxial layer 20.

As shown in the figures, the internal structure of the power transistor device 100 of the present invention integrates both the transistor 1 and the snubber circuit 2. The dielectric layer 80 of the snubber circuit 2 can be made of a dielectric material with an appropriate dielectric constant and geometric dimensions (including film thickness, length, width, etc.) to adjust its capacitance value. Additionally, the polycrystalline silicon layer 90 of the snubber circuit 2 can have its resistance value adjusted through the doping concentration of the polycrystalline silicon and the geometric dimensions of the polycrystalline silicon film (including film thickness, length, width, etc.), thereby determining the overall resistance value of the polycrystalline silicon layer 90, epitaxial layer 20, and substrate 10 between the source metal 60 and the drain metal 70 in the snubber circuit 2. When the power transistor device 100 of the present invention is applied in a circuitry, during the switching process from the on-state to the off-state, the current generated by a high-voltage surge will flow through the loop formed by the snubber circuit 2 and the switch. The capacitor C in the snubber circuit will block the DC portion of the surge current, while the resistor R in the snubber circuit will dissipate the AC portion of the surge current passing through the capacitor C for reducing the peak surge voltage experienced at the load end and thereby protecting the gate dielectric layer of the transistor in the power transistor device.

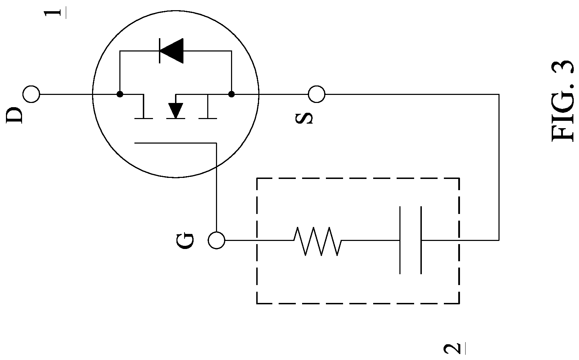

Please refer to FIG. 3, which illustrates a circuit schematic of a power transistor device according to the second embodiment of the present invention. Similar to the previous embodiment, this power transistor device includes a transistor 1 identical to conventional designs and a snubber circuit 2 integrated concurrently with the transistor 1 within the device. Specifically, as shown in FIG. 3, the snubber circuit 2 of the second embodiment is a resistor-capacitor (RC) snubber circuit connected between a source S and a gate G of the transistor 1.

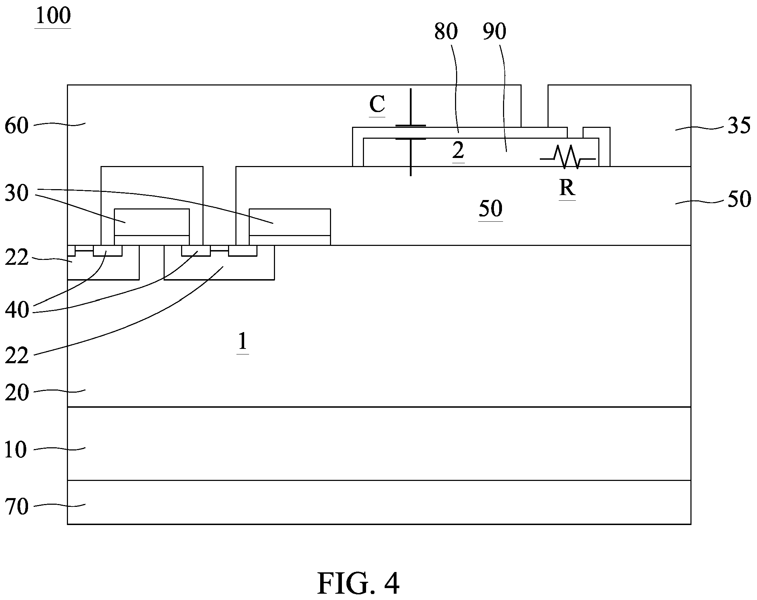

Please refer to FIG. 4 in conjunction, which illustrates a cross-sectional schematic of the power transistor device 100 according to the second embodiment of the present invention as shown in FIG. 3. Evidently, the power transistor device 100 of the present invention integrates the transistor 1 and the snubber circuit 2 within a single device structure, as detailed below. Similar to the previous embodiment, this power transistor device 100 includes a substrate 10 with an epitaxial layer 20 disposed thereon. Next, a gate 30 is formed on the epitaxial layer 20, and a P-type well region 22 and a source 40 are formed in the surface region of the epitaxial layer 20. Subsequently, an interlayer dielectric layer 50 is formed on the epitaxial layer 20 to cover the gate 30. Then, the dielectric layer 80 and polycrystalline silicon layer 90 of the snubber circuit 2 are formed above the interlayer dielectric layer 50, adjacently arranged and electrically connected in series. Finally, a metallization interconnect process is performed to form a gate metal 35, a source metal 60, and a drain metal 70, respectively. The source metal 60 is electrically connected to the source 40 of the transistor 1 and the dielectric layer 80 of the snubber circuit 2. On the other hand, the gate metal 35 is electrically connected to the polycrystalline silicon layer 90 of the snubber circuit 2.

As shown in FIG. 3 and FIG. 4, the internal structure of the power transistor device 100 of the present invention integrates both the transistor 1 and the snubber circuit 2 on the same substrate 10. Similar to the previous embodiment, the dielectric layer 80 of the snubber circuit 2 can have its capacitance value adjusted by selecting a dielectric material with an appropriate dielectric constant and geometric dimensions of the dielectric film. Additionally, the polycrystalline silicon layer 90 can have its resistance value adjusted through the doping concentration of the polycrystalline silicon and the geometric dimensions of the polycrystalline silicon film. When the power transistor device 100 of the present invention is applied in a circuit, during the switching process from the on-state to the off-state, the current generated by a high-voltage surge will flow through the loop formed by the snubber circuit 2 and the switch. The capacitor C (i.e., dielectric layer 80) in the snubber circuit will block the DC portion of the surge current, while the resistor R (i.e., polycrystalline silicon layer 90) in the snubber circuit will dissipate the AC portion of the surge current passing through the capacitor C for reducing the peak surge voltage experienced at the load end and thereby protecting the gate dielectric layer of the transistor in the power transistor device.

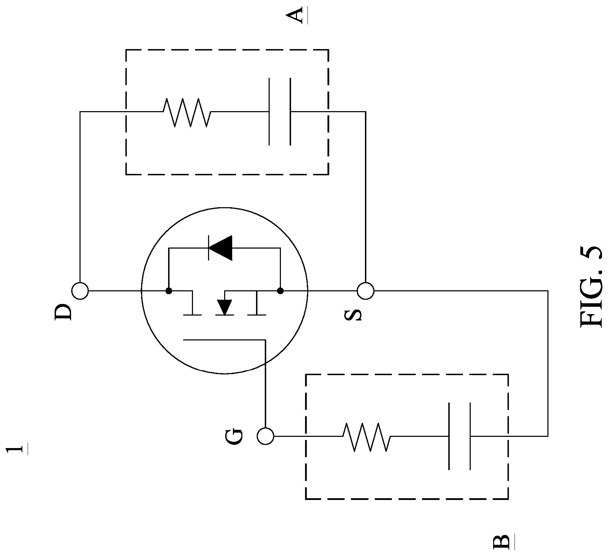

Please refer to FIG. 5, which illustrates a circuit schematic of a power transistor device according to the third embodiment of the present invention. The third embodiment combines the first and second embodiments described above, integrating a conventional transistor 1 with two snubber circuits simultaneously. Specifically, as shown in FIG. 5, snubber circuit A is an RC snubber circuit connected between a source S and a drain D of the transistor 1, and snubber circuit B is an RC snubber circuit connected between a source S and a gate G of the transistor 1.

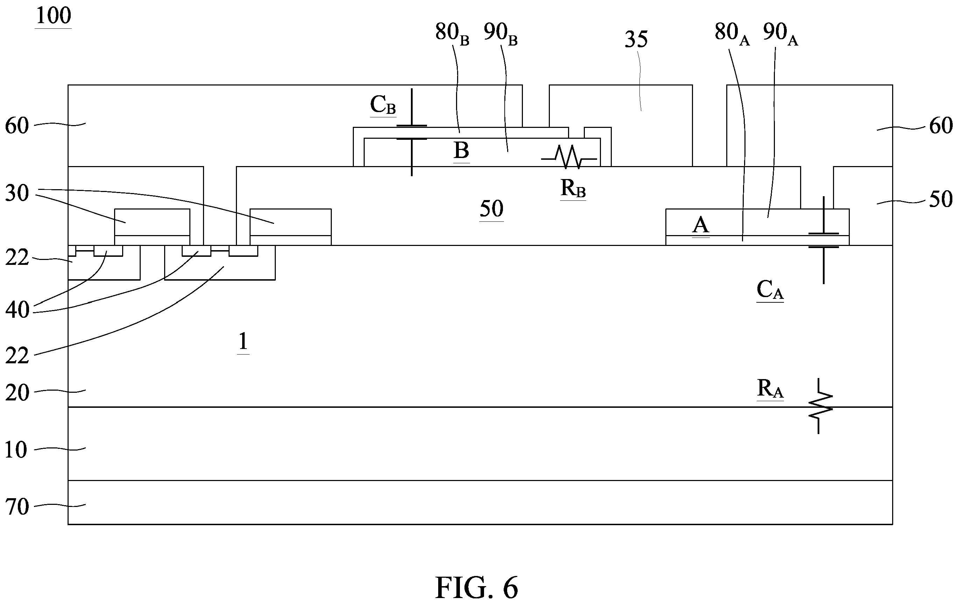

Please refer to FIG. 6 in conjunction, which illustrates a cross-sectional schematic of the power transistor device 100 according to the third embodiment of the present invention as shown in FIG. 5. Evidently, the power transistor device 100 of the present invention integrates the transistor 1, snubber circuit A, and snubber circuit B within a single device structure, as detailed below. Similar to the previous embodiments, the substrate 10 of this power transistor device 100 has an epitaxial layer 20 disposed thereon, with a gate 30 and the dielectric layer 80_{A} and polycrystalline silicon layer 90_{A} of snubber circuit A formed on the epitaxial layer 20. The surface region of the epitaxial layer 20 includes a P-type well region 22 and a source 40. Additionally, an interlayer dielectric layer 50 is formed on the epitaxial layer 20 to cover the gate 30 and the dielectric layer 80_{A} and polycrystalline silicon layer 90_{A} of snubber circuit A. Next, the dielectric layer 80_{B} and polycrystalline silicon layer 90_{B} of snubber circuit B are formed above the interlayer dielectric layer 50. Finally, the metallization interconnect includes a gate metal 35, a source metal 60, and a drain metal 70. The source metal 60 is electrically connected to the source 40 of the transistor 1, the polycrystalline silicon layer 90_{A} of snubber circuit A, and the dielectric layer 80_{B} of snubber circuit B. On the other hand, the gate metal 35 is electrically connected to the polycrystalline silicon layer 90_{B} of snubber circuit B. The drain metal 70 is electrically connected to the dielectric layer 80_{A} of snubber circuit A through the substrate 10 and the epitaxial layer 20.

As shown in FIG. 5 and FIG. 6, the internal structure of the power transistor device 100 in the third embodiment integrates the transistor 1, snubber circuit A, and snubber circuit B simultaneously. Snubber circuit A includes an RC snubber circuit with a resistor R_{A} and a capacitor C_{A}, wherein the resistor R_{A} is the overall resistance of the first polycrystalline silicon layer 90_{A}, epitaxial layer 20, and substrate 10 between the source metal 60 and the drain metal 70, and the capacitor C_{A} is determined by the first dielectric layer 80_{A}. Snubber circuit B includes an RC snubber circuit with a resistor R_{B} and a capacitor C_{B}, wherein the resistor R_{B} exists between the polycrystalline silicon layer 90_{B} and the gate metal 35, and the capacitor C_{B} is determined by the second dielectric layer 80_{B}. Snubber circuit A and snubber circuit B provide a more comprehensive suppression of high-voltage surges in the power transistor device for thereby protecting the gate dielectric layer of the transistor in the power transistor device.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A semiconductor device, comprising:
a substrate;
a transistor, disposed on the substrate; and
a snubber circuit, disposed on the substrate, and electrically connected to the transistor, wherein the snubber circuit has a polycrystalline silicon layer and a dielectric layer, adjacently arranged and electrically connected in series,
wherein the polycrystalline silicon layer is electrically connected to a source of the transistor, and the dielectric layer is electrically connected to a drain of the transistor so that the polycrystalline silicon layer acts as a resistor and the dielectric layer acts as a capacitor.

2. The semiconductor device of claim 1, wherein the substrate is a silicon carbide substrate.

3. The semiconductor device of claim 1, further comprising an epitaxial layer disposed on the substrate, wherein the dielectric layer is disposed on the epitaxial layer.

4. The semiconductor device of claim 3, further comprising a source metal disposed above the epitaxial layer, electrically connected to the source and the polycrystalline silicon layer.

5. The semiconductor device of claim 4, further comprising a drain metal, disposed on a backside of the substrate, acting as the drain, wherein the polycrystalline silicon layer, the epitaxial layer, and the substrate, between the source metal and the drain metal, exhibit the resistance.

6. A semiconductor device, comprising:
a substrate;
a transistor, disposed on the substrate; and
a snubber circuit, disposed on the substrate, and electrically connected to the transistor, wherein the snubber circuit has a polycrystalline silicon layer and a dielectric layer, adjacently arranged and electrically connected in series,
wherein the polycrystalline silicon layer is electrically connected to a gate of the transistor, and the dielectric layer is electrically connected to a source of the transistor so that the polycrystalline silicon layer acts as a resistor and the dielectric layer acts as a capacitor.

7. The semiconductor device of claim 6, wherein the substrate is a silicon carbide substrate.

8. The semiconductor device of claim 6, further comprising an epitaxial layer and an interlayer dielectric layer, the epitaxial layer being disposed on the substrate, the interlayer dielectric layer being disposed on the epitaxial layer, wherein the polycrystalline silicon layer is disposed on the interlayer dielectric layer.

9. The semiconductor device of claim 8, further comprising a gate metal, disposed on the interlayer dielectric layer, electrically connected to the gate, wherein the polycrystalline silicon layer and the gate metal have the resistance therebetween.

10. The semiconductor device of claim 8, further comprising a source metal, disposed on the interlayer dielectric layer, electrically connected to the source and the dielectric layer.

11. A semiconductor component, comprising:
a substrate;
a transistor, disposed on the substrate;
a first snubber circuit, disposed on the substrate and electrically connected to the transistor, the first snubber circuit having a first polycrystalline silicon layer and a first dielectric layer, the first polycrystalline silicon layer and the first dielectric layer being adjacently arranged and electrically connected in series; and
a second snubber circuit, disposed on the substrate and electrically connected to the transistor, the second snubber circuit having a second polycrystalline silicon layer and a second dielectric layer, the second polycrystalline silicon layer and the second dielectric layer being adjacently arranged and electrically connected in series,
wherein the first polycrystalline silicon layer is electrically connected to a source of the transistor, and the first dielectric layer is electrically connected to a drain of the transistor so that the first polycrystalline silicon layer acts as a first resistor and the first dielectric layer acts as a first capacitor,
the second polycrystalline silicon layer is electrically connected to a gate of the transistor, and the second dielectric layer is electrically connected to the source of the transistor so that the second polycrystalline silicon layer acts as a second resistor and the second dielectric layer acts as a second capacitor.

12. The semiconductor device of claim 11, wherein the substrate is a silicon carbide substrate.

13. The semiconductor device of claim 11, further comprising an epitaxial layer disposed on the substrate, wherein the dielectric layer is disposed on the epitaxial layer.

14. The semiconductor device of claim 13, further comprising an interlayer dielectric layer, the interlayer dielectric layer being disposed on the epitaxial layer, wherein the second polycrystalline silicon layer is disposed on the interlayer dielectric layer.

15. The semiconductor device of claim 14, further comprising a gate metal, disposed on the interlayer dielectric layer, electrically connected to the gate, wherein the second polycrystalline silicon layer and the gate metal have the second resistance therebetween.

16. The semiconductor device of claim 14, further comprising a source metal, disposed on the interlayer dielectric layer, electrically connected to the source, the first polycrystalline silicon layer and the second dielectric layer.

17. The semiconductor device of claim 16, further comprising a drain metal, disposed on a backside of the substrate, acting as the drain, wherein the first polycrystalline silicon layer, the epitaxial layer, and the substrate, between the source metal and the drain metal, exhibit the first resistance.
